# EUROPÄISCHE PATENTSCHRIFT

(11) **EP 3 844 854 B1**
(45) Veröffentlichungstag und Bekanntmachung des Hinweises auf die Patenterteilung: **05.06.2024**
(21) Anmeldenummer: 19739984.3
(22) Anmeldetag: 12.07.2019
(51) Int. Cl.: H02J 7/00

(54) **AKKUPACK SOWIE LADEVERFAHREN FÜR EIN AKKUPACK**
BATTERY PACK AND CHARGING METHOD FOR A BATTERY PACK
BLOC-BATTERIE AINSI QUE PROCÉDÉ DE CHARGE POUR UN BLOC-BATTERIE

(30) Priorität: 29.08.2018 DE 102018214609
(43) Veröffentlichungstag der Anmeldung: 07.07.2021
(73) Patentinhaber: Robert Bosch GmbH, 70442 Stuttgart (DE)
(72) Erfinder: MACK, Juergen, 73035 Goeppingen (DE); SEGRET, Mickael, 70569 Stuttgart (DE); KLEE, Christoph, 70599 Stuttgart (DE)
(86) Internationale Anmeldenummer: PCT/EP2019/068820
(87) Internationale Veröffentlichungsnummer: WO 2020/043386

(56) Entgegenhaltungen:
- DE-A1-102012 201 381
- DE-A1-102013 220 684
- DE-A1-102015 219 823

## Beschreibung

### Stand der Technik

Die vorliegende Erfindung betrifft einen Akkupack mit einer vorgegebenen Anzahl von miteinander verschalteten einzelnen Akkuzellen und einer Überwachungseinheit. Aus der DE 10 2015 219 823 A1 und der DE 10 2012 201 381 A1 sind derartige Akkupacks mit einer vorgegebenen Anzahl von miteinander verschalteten einzelnen Akkuzellen und einer als Single-Cell-Monitoring-Schaltung (SCM) ausgebildeten Überwachungseinheit mit einer passiven Eingangsschaltung bekannt.

In einem derartigen Akkupack werden gebräuchlicher Weise zur Erzielung höherer elektrischer Leistungen mehrere Akkuzellen elektrisch miteinander in Reihe und/oder parallel verschaltet. Um eine besonders hohe Energiedichte zu erzielen, kommen dabei insbesondere Lithium-Ionen-Akkus oder Lithium-Polymer-Akkus zum Einsatz. Bei diesen Akkutechnologien ist es erforderlich, dass jede Zelle in einem bestimmten Betriebsparameterbereich betrieben wird, der durch Spannung, Strom und Temperatur definiert ist. Um sicherzustellen, dass dieser Betriebsparameterbereich für jede einzelne Akkuzelle des Akkupacks stets erfüllt ist, werden die Spannungen der einzelnen Akkuzellen z.B. mittels des sogenannten SCM-Verfahrens kontinuierlich überwacht. Durch das SCM-Verfahren ist sichergestellt, dass vor allem beim Aufladen keine Akkuzelle oberhalb ihrer zulässigen Ladeschlussspannung bzw. Zielspannung betrieben wird. Für das SCM-Verfahren ist es erforderlich, dass elektrische Signale von Verbindungspunkten zwischen zwei in Reihe geschalteten Akkuzellen die Überwachungseinheit weitergeleitet werden.

Eine Umsetzung des SCM-Verfahrens erfolgt z.B. mittels einer sogenannten SCM-Schaltung, wie beispielsweise der integrierten Schaltung Texas Instruments^{®} BQ771800 oder einer Kombination aus einem Microcontroller und einem sogenannten passiven Frontend bzw. einer Eingangsschaltung. Die elektrische Verbindung zwischen den Akkuzellen-Verbindungspunkten und der SCM-Schaltung wird typischerweise mit einer sogenannten "open wire detection" überprüft. In diesem Zusammenhang werden nacheinander Schalter kurzzeitig aktiviert, die die Spannungsmesseingänge der SCM-Schaltung zumindest kurzzeitig überbrücken. Infolgedessen wird ein jeweils zugeordneter Filterkondensator kurzzeitig definiert entladen. Anschließend wird der betreffende Schalter wieder geöffnet. Nach einer kurzen Zeit wird die Spannung am kurzzeitig überbrückten Spannungsmesseingang der SCM-Schaltung wieder überprüft. Falls ein "o-pen wire"' vorliegt, wäre der Kondensator noch nicht wieder aufgeladen, was mittels der SCM-Schaltung erfassbar ist. Damit die SCM-Schaltung auch bei einzelnen elektrischen Fehlern innerhalb der Eingangsschaltung zuverlässig die Ladeschlussspannung begrenzt, ist es darüber hinaus erforderlich, die relevanten Schaltungsteile einzelfehlersicher auszulegen. Dies erfordert jedoch eine aufwändige, redundante Auslegung der betreffenden Schaltungsteile. Die Redundanz der Eingangsschaltung der SCM-Schaltung ist zudem problematisch, da die elektrischen Signale von den einzelnen Abzweigen der Akkuzellen in dem Sinne besonderen Isolationsschutzes bedürfen, d.h. dass sie in einem Fehlerfall hohe Ströme und/oder Spannung führen können, die zu thermischen Folgefehlern führen können. Weiterhin können elektrische Fehler in der Eingangsschaltung einer SCM-Schaltung auftreten, die durch die vorbekannte "open wire detection" nicht erfassbar sind.

Aus der DE 10 2013 220 684 A1 ist ferner Batteriemanagementsystem zum Überwachen und Regeln des Betriebs einer nachladbaren Batterie, welche eine Mehrzahl von elektrisch miteinander verschalteten, jeweils wenigstens eine Batteriezelle umfassenden Batteriemodulen aufweist bekannt. Das Batteriemanagementsystem umfasst wenigstens eine Steuergeräteeinheit und wenigstens eine Zellüberwachungseinheit, wobei die wenigstens eine Zellüberwachungseinheit ausgebildet ist, Daten bezüglich wenigstens eines Betriebsparameters von wenigstens einer Batteriezelle zu empfangen, die empfangenen Daten zu erfassen und die erfassten Daten an die wenigstens eine Steuergeräteeinheit zu übertragen. Ferner ist die wenigstens eine Zellüberwachungseinheit dazu ausgebildet, wenigstens ein Fehlerereignis in Bezug auf die wenigstens eine Batteriezelle zu detektieren und ein Abschalten des die wenigstens eine Batteriezelle umfassenden Batteriemoduls auszulösen.

Gegenüber dem bekannten Stand der Technik besteht die Aufgabe der Erfindung darin, eine Fehlererkennung unabhängig von individuellen Eigenschaften des Akkupacks, wie z.B. Alterungseffekten, einem Ladezustand der einzelnen Ackuzellen oder aktuell fließenden Lade- oder Entladeströmen zu ermöglichen.

### Offenbarung der Erfindung

Die vorliegende Erfindung betrifft einen Akkupack mit einer vorgegebenen Anzahl von miteinander verschalteten einzelnen Akkuzellen und einer Überwachungseinheit, insbesondere nach Art einer Single-Cell-Monitoring-Schaltung (SCM), für die Überwachung der einzelnen Akkuzellen, wobei die Überwachungseinheit mindestens einen Spannungsmesser zur Erfassung von Spannungen der einzelnen Akkuzellen mit jeweils zugeordneten elektronischen Schaltern sowie mit einer passiven Eingangsschaltung, welche mehrere Widerstände und Kondensatoren aufweist und dazu ausgebildet ist, unterschiedliche elektrische Fehler innerhalb der passiven Eingangsschaltung mittels einer der Überwachungseinheit zugeordneten Zeitmesseinheit anhand einer Messung von Anstiegszeiten der Spannung der einzelnen Akkuzellen zu erkennen. Zur Lösung der gestellten Aufgabe werden die elektrischen Fehler innerhalb der passiven Eingangsschaltung jeweils durch eine absolute und/oder relative Auswertung der Anstiegszeiten der Spannungen der einzelnen Akkuzellen durch zumindest kurzzeitiges Überbrücken jeweils eines der Spannungsmesser der Überwachungseinheit mittels eines zugeordneten Schalters erkannt. Infolgedessen basiert die Fehlererkennung auf einer Bewertung der Anstiegszeiten und nicht auf einer Erfassung von absoluten Spannungswerten, so dass die Fehlererkennung unabhängig von individuellen Eigenschaften des Akkupacks, wie z.B. Alterungseffekten, einem Ladezustand einzelner Akkuzellen und aktuell fließenden Lade- oder Entladeströmen, ist. Es kann für jede Akkuzelle ein individueller Spannungsmesser, insbesondere ein Analog-Digitalwandler, innerhalb der Überwachungseinheit bzw. des Mikrocontrollers vorgesehen sein. Alternativ kann auch mit nur einem Spannungsmesser und einem diesem vorgeschalteten, mehrkanaligen Analogmultiplexer eine zeitlich versetzte Messung der einzelnen Spannungen erfolgen. Die Erfindung ermöglicht es, die passive Eingangsschaltung der Überwachungseinheit kontinuierlich auf das Vorhandensein von unterschiedlichen elektrischen Fehlern hin zu überprüfen. Eine aus Sicherheitsgründen ansonsten notwendige redundante Auslegung der passiven Eingangsschaltung kann entfallen. Sämtliche Funktionalitäten der Überwachungseinheit sind vorzugsweise mit einem integrierten digitalen Mikrocontroller realisiert.

Bevorzugt weist die passive Eingangsschaltung mehrere Widerstände und Kondensatoren auf. Hierdurch lassen sich zeitliche Anstiegskurven bzw. Verläufe der Spannung erzeugen.

Bevorzugt weist die passive Eingangsschaltung mehrere Zusatzwiderstände auf, die jeweils in Reihe mit einem der Widerstände geschaltet sind, wobei die Anzahl der Zusatzwiderstände gleich der vorgegebenen Anzahl der Akkuzellen ist. Hierdurch ist eine Erkennung der elektrischen Fehler über die Auswertung einer abfallenden Spannungskurve möglich. Zudem lassen sich somit auch gegenseitig kompensierende Fehler erkennen, die auftreten können, wenn beispielsweise ein Widerstandswert fehlerbedingt ansteigt und eine Kapazität des zugeordneten Kondensators fehlerbedingt entsprechend fällt und somit das Produkt aus dem Widerstandswert und der Kapazität nach außen hin im Wesentlichen unverändert bleibt.

Bevorzugt sind die Zusatzwiderstände kleiner oder gleich als die Widerstände bemessen. Hierdurch lässt sich die Erkennung der elektrischen Fehler weiter verbessern. Besonders vorteilhaft gestaltet sich die Fehlerdetektion, wenn die Zusatzwiderstände einen Widerstandswert zwischen 20% und 80% vom Widerstandswert der Widerstände aufweisen.

Bei einer Weiterbildung ist vorgesehen, dass die Überwachungseinheit als eine integrierte Schaltung ausgeführt ist. Infolgedessen ist eine besonders raumsparende Integration in vorhandene Akkupack-Designs möglich.

Darüber hinaus betrifft die Erfindung ein Verfahren zur Erfassung von elektrischen Fehlern innerhalb einer passiven Eingangsschaltung einer Überwachungseinheit, insbesondere nach Art einer SCM-Schaltung, für die Überwachung einer vorgegebenen Anzahl von einzelnen Akkuzellen eines erfindungsgemäßen Akkupacks, wobei die Eingangsschaltung mehrere Widerstände und Kondensatoren aufweist, gekennzeichnet durch die folgende Schritte:
a) Start eines Ladebetriebs des Akkupacks,
b) Messen einer Spannung einer Akkuzelle zu einem ersten Zeitpunkt,
c) zumindest kurzzeitiges Überbrücken eines Spannungsmessers der Überwachungseinheit mittels eines zugeordneten Schalters,
d) Messen einer Anstiegszeit der Spannung bis eine zu einem zweiten Zeitpunkt gemessene Spannung das 0,1 - bis 0,9-Fache der in Schritt b) gemessenen Spannung erreicht hat,
e) Wiederholen der Schritte b) bis d) für jede der vorgegebenen Anzahl von Akkuzellen des Akkupacks,
f) absolutes und/oder relatives Auswerten der Anstiegszeiten der Spannung der einzelnen Akkuzellen anhand eines vorgegebenen Toleranzbereichs, und
g) Stopp des Ladebetriebs des Akkupacks, wenn mindestens eine Anstiegszeit außerhalb des Toleranzbereichs liegt und somit ein Fehler innerhalb der passiven Eingangsschaltung der Überwachungseinheit erkannt wurde, andernfalls Fortsetzen des Ladebetriebs und zyklisches Wiederholen der Schritte b) bis g).

Das Verfahren ermöglicht eine kontinuierliche Überwachung der Eingangsschaltung auf das Vorhandensein von etwaigen elektrischen Fehlern. Eine Zykluszeit für einen vollständigen Verfahrensdurchlauf kann beispielsweise bis zu einer Sekunde betragen.

Bevorzugterweise wird bei der vorgegebenen Anzahl gleich Eins die Anstiegszeit um einen zeitlichen Korrekturfaktor berichtigt, wenn der erste Spannungsmesser nicht über einen elektrischen Widerstand mit einem Minuspol des Akkupacks verbunden ist. Dabei wird vorzugsweise bei einer Zelle, deren Eingangsfilter sich von dem Eingangsfilter anderer Zellen unterscheidet, die Anstiegszeit um einen zeitlichen Korrekturfaktor berichtigt. Hierdurch lässt sich eine aufgrund des fehlenden Widerstands hervorgerufene elektrische Asymmetrie der passiven Eingangsschaltung der Überwachungseinheit numerisch einfach ausgleichen.

### Kurze Beschreibung der Zeichnungen

Die Erfindung ist anhand von in den Zeichnungen dargestellten Ausführungsbeispielen in der nachfolgenden Beschreibung näher erläutert. Es zeigen:
- Fig. 1: ein erfindungsgemäßes Akkupack mit einer Überwachungseinheit und einer Eingangsschaltung zur Überwachung von einzelnen Akkuzellen,
- Fig. 2: eine schematische Ansicht eines Algorithmus zur Erkennung von elektrischen Fehlern innerhalb der Eingangsschaltung der Überwachungseinheit des Akkupacks von Fig. 1 mit Hilfe der Überwachungseinheit,
- Fig. 3: eine schematische Ansicht eines alternativen Algorithmus zur Erkennung der elektrischen Fehler, und
- Fig. 4: eine weitere Ausführungsform eines erfindungsgemäßen Akkupacks.

### Beschreibung der Ausführungsbeispiele

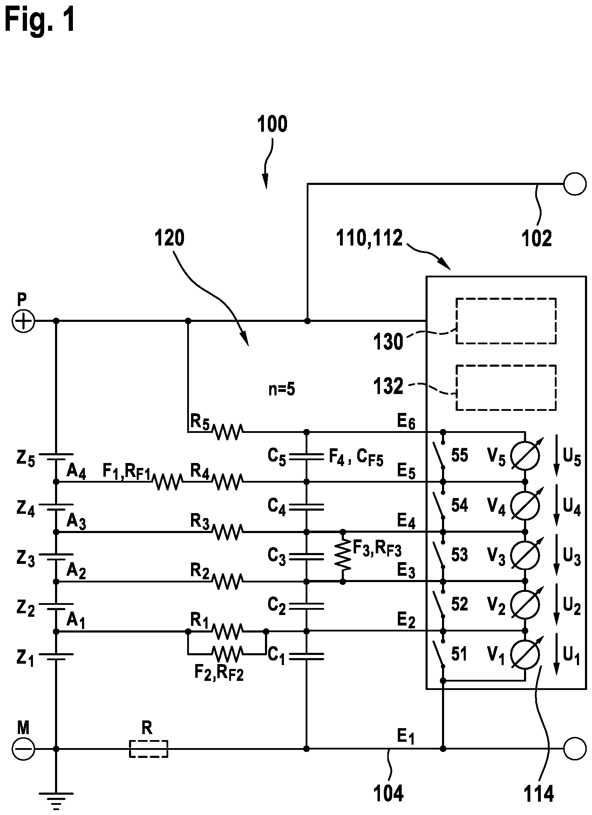

Fig. 1 zeigt einen Akkupack 100 mit hier lediglich exemplarisch einer Anzahl von n gleich fünf (n=5) Akkuzellen Z_{1,...,5}, die nur beispielhaft in Reihe geschaltet sind. Alternativ können die Akkuzellen Z_{1,...,5} zur Spannungs- und Stromanpassung beliebig in Reihe oder parallel geschaltet werden. Zwischen jeweils zwei in Reihe liegenden Akkuzellen Z_{1,...,5} befindet sich jeweils ein (Mitten-)Abgriff A_{1,...,4}. Der Akkupack 100 verfügt über einen Minuspol M bzw. einen Massezweig und einen Pluspol P, wobei der Minuspol M mit dem Minuspol der Akkuzelle Z₁ und der Pluspol P mit dem Pluspol der Akkuzelle Z₅ identisch ist. An den Minuspol M bzw. den Massezweig und an den Pluspol P ist mit Hilfe von zwei elektrischen Anschlussleitungen 102, 104 ein beliebiger, hier nicht dargestellter, elektrischer Verbraucher anschließbar.

Weiterhin umfasst der Akkupack 100 eine elektronische Überwachungseinheit 110 zur permanenten Überwachung jeder einzelnen Akkuzelle Z_{1,...,5} des Akkupacks 100, die insbesondere nach Art einer SCM-Schaltung 112 ausgeführt ist, wobei der Überwachungseinheit 110 eine passive Eingangsschaltung 120 vorgeschaltet ist. In die Überwachungseinheit 110 sind vorzugsweise weiterhin ein leistungsfähiger digitaler Mikrokontroller 130 und eine Zeitmesseinheit 132 integriert. Die Überwachungseinheit 110 ist bevorzugt als eine integrierte, monolithische Schaltung 114 ausgeführt.

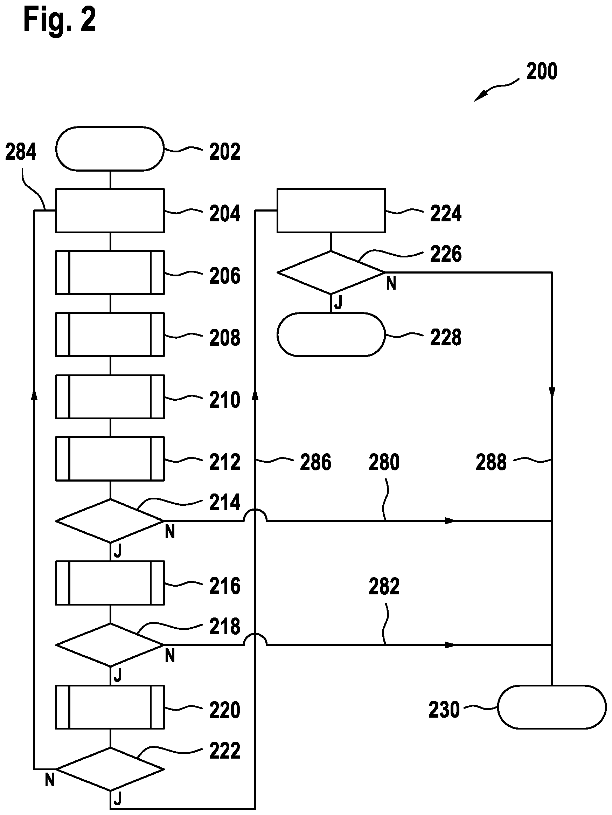

Bevorzugt weist die passive Eingangsschaltung 120 mehrere Widerstände R_{1,..,n} und Kondensatoren C_{1,...,n} auf. Die Eingangsschaltung 120 der Überwachungseinheit 110 umfasst hier der Anzahl n gleich fünf (n=5) entsprechend ebenfalls fünf Widerstände R_{1,...,5}, wobei die Widerstände R_{1,...,4} jeweils in Reihe hinter den Abgriffen A_{1,...,4} der einzelnen Akkuzellen Z_{1,...,5} liegen. Der Widerstand R₅ ist jedoch direkt mit dem Pluspol P bzw. dem Pluspol der Akkuzelle Z₅ verbunden. Weiterhin enthält die Eingangsschaltung illustrativ fünf Kondensatoren C_{1,...,5}, die jeweils parallel an zwei unmittelbar benachbarten Eingängen E_{1,...,6} der Überwachungseinheit 110 angeschlossen sind. Es wird darauf hingewiesen, dass die Überwachungseinheit 110 auch mehr oder weniger als fünf Widerstände R_{1,...,5} und/oder Kondensatoren C_{1,...,5} aufweisen kann. So können an Stelle eines Widerstands, z.B. des Widerstands R₁, auch mehrere Widerstände angeordnet sein, die in Reihe oder parallel zueinander angeordnet sind. Bevorzugt wird ein in Fig. 2 dargestellter Widerstand R_{1,...,5} durch zwei in Reihe angeordnete Widerstände ausgebildet, wodurch ein entsprechend zugeordneter Isolationsabstand erhöht wird. Darüber hinaus sind bevorzugt die in Fig. 2 dargestellten Kondensatoren C_{1,...,5} als zwei in Reihe angeordnete Kondensatoren ausgebildet, sodass bei einer mechanischem Beschädigung eines der beiden Kondensatoren kein Kurzschluss entstehen kann.

Die Überwachungseinheit 110 weist vorzugsweise mindestens einen Spannungsmesser V_{1,...,n} zur Erfassung von Spannungen U_{1,...,n}, auf. Zwischen jeweils zwei benachbarten Eingängen E_{1,2}, E_{2,3}, E_{3,4}, E_{4,5} sowie E_{5,6} der Überwachungseinheit 110 ist hier beispielhaft jeweils ein Spannungsmesser V_{1,...5} angeschlossen, der jeweils mittels eines vom Mikrokontroller betätigbaren elektronischen Schalters S_{1,...,5} individuell überbrückbar bzw. kurzschließbar ist. Die Spannungsmesser V_{1,...,5} in der Überwachungseinheit 110 können zum Beispiel mit elektronischen Analog-Digitalwandlern (ADC's) des Mikrokontrollers 130 realisiert sein. Anstatt der hier nur beispielhaft gezeigten fünf Spannungsmesser V_{1,...,5} kann auch nur ein Spannungsmesser vorgesehen sein, auf den mittels eines nicht dargestellten Analogmultiplexers die Eingänge E_{1,...,6}, unter Einschluss der elektronischen Schalter S_{1,...,5}, zeitlich nacheinander aufschaltbar sind. Mit Hilfe der hier lediglich beispielhaft fünf Spannungsmesser V_{1,...,5} lassen sich die (Eingangs-)Spannungen U_{1,...,5} mit Hilfe der Überwachungseinheit 110 erforderlichenfalls zeitgleich erfassen.

Die Überwachungseinheit 110 ist dazu ausgebildet, verschiedene, hier beispielhaft angeführte elektrische Fehler F_{1,..,4}, innerhalb der passiven Eingangsschaltung 120, insbesondere anhand einer Messung und einer Bewertung einer jeweiligen Anstiegszeit T_{An 1,...,5} einer algorithmisch ausgewählten (Eingangs-) Spannung U_{1,...,n}, nach einem zumindest kurzeitigen Kurzschließen, bzw. Überbrücken eines der Spannungsmesser V_{1,...5}, mittels der elektronischen Schalter S_{1,...,5} mit Hilfe der Zeitmesseinheit 132 zu erfassen. Bevorzugterweise werden die Spannungen U_{1,...,n}, mit einer Zykluszeit von weniger als einer Sekunde kontinuierlich umlaufend gemessen und die betreffenden Anstiegszeiten T_{An 1,...,5} entsprechend von der Überwachungseinheit 110 erfasst und anhand eines Toleranzbereichs absolut und/oder relativ bewertet.

Ein erster Fehler F₁ in Form eines zusätzlichen Serienwiderstands R_{F1}, der zum Beispiel durch eine schlechte Lötung entstehen kann, wird mindestens die Anstiegszeiten T_{An 4,5} an den beiden Eingängen E_{4,5} der Überwachungseinheit 110 nachweisbar erhöhen. Ein zweiter Fehler F₂ in Form eines parasitären Parallelwiderstands R_{F2}, der beispielsweise durch eine Verschmutzung einer nicht dargestellten Leiterplatte der Eingangsschaltung 120 hervorgerufen werden kann, wird zumindest die Anstiegszeit T_{An 1} an dem Eingang E₁ der Überwachungseinheit 110 nachweisbar erhöhen. Ein dritter Fehler F₃ in Form eines parallel zu dem Kondensator C₃ liegenden Widerstands R_{F3}, der beispielsweise durch einen bereichsweisen Isolierfehler im Dielektrikum des Kondensators C₃ entstehen kann, wird zumindest zu einer messbaren Veränderung der Anstiegszeit T_{An 3} des Eingangs Es der Überwachungseinheit 110 führen. Ein vierter Fehler F₄ in Form eines veränderten Kapazitätswerts C_{F5}, wie er zum Beispiel durch eine Schädigung des Dielektrikums des Kondensators C₅ auftreten kann, wird die Anstiegszeit T_{An 5} zumindest am Eingang E₅ der Überwachungseinheit 110 nachweisbar beeinflussen.

Verfahrensgemäß wird vorzugsweise zunächst eine algorithmisch ausgewählte Spannung U_{1,...,5} (t₁) unmittelbar vor einem zumindest kurzzeitigen Kurzschließen eines der Spannungsmesser V_{1,...,5} in einem ersten Zeitpunkt t₁ ermittelt. Nach einem zumindest kurzzeitigen Kurzschließen des ausgewählten Spannungsmessers V_{1,...,5} wird die betreffende aktuelle Spannung U_{1,...,5}(t₂) bevorzugt fortlaufend weiter gemessen, bis diese einen Bruchteil zwischen 0,1 und 0,9 der betreffenden ursprünglichen Spannung U_{1,...,5}(t₁) erreicht hat und damit eine Abbruchbedingung erfüllt ist. Die Anstiegszeit T_{An 1,..,n} der betreffenden Spannung U_{1,...,5} folgt dann aus der Differenz zwischen den beiden Zeitpunkten t₂ und t₁. Der zweite Zeitpunkt t₂ ergibt sich hierbei durch das Stoppen der Zeit ab dem ersten Zeitpunkt t₁ bis zum Erreichen der vorstehenden Abbruchbedingung. Der erste und der zweite Zeitpunkt t₁, t₂ werden bevorzugt mittels der gleichfalls vom Mikrokontroller 130 gesteuerten Zeitmesseinheit 132 bestimmt. Je kleiner der als Abbruchbedingung dienende Bruchteil ist, desto schneller kann die Fehlererkennung erfolgen. Bei mittelgroßen Bruchteilen steigt die Genauigkeit, während bei großen Bruchteilen die Empfindlichkeit geringer wird. Bevorzugterweise wird daher die Messung der betreffenden Spannung U_{1,...,5}(t₂) mit einem Bruchteil von 0,5 als Abbruchbedingung durchgeführt. Die beispielhaften vier elektrischen Fehler F_{1,...,4} innerhalb der passiven Eingangsschaltung 120 sind dann durch eine absolute und/oder relative Auswertung der solchermaßen ermittelten Anstiegszeiten T_{An 1,...,5} der betreffenden Spannung U_{1,...5} anhand eines in der Überwachungseinheit 110 vordefinierten Toleranzbereichs erfassbar.

Ein Vorteil der Überwachungseinheit 110 des Akkupacks 100 liegt darin, dass eine Bewertung der betreffenden Anstiegszeiten T_{An 1,...,5}, und nicht eines absoluten Spannungswertes, erfolgt. Zum einen sind hierdurch die Toleranzbereiche zur Auswertung unabhängig von dem jeweiligen Ladezustand der einzelnen Akkuzellen Z_{1,..,5} des Akkupacks 100 und zum anderen existieren marktübliche Mikrokontroller 130, bei denen zum Beispiel ein Schwellwert für einen Analog-Digitalwandler bzw. einen Spannungsmesser V_{1,...,5} vorgebbar ist und nur die Anstiegszeit T_{An 1,...,5} gemessen werden muss, bis der vorgegebene Schwellwert erreicht ist. Aufgrund dieses Umstandes stehen mehr Ressourcen des Mikrokontrollers 130 für anderweitige Aufgaben zur Verfügung. Für die Anstiegszeit T_{An 1} ist gegebenenfalls noch ein Korrekturfaktor rechnerisch zu berücksichtigen - wenn wie hier gezeigt - der Eingang E₁ nicht über einen elektrischen (Ausgleichs-) Widerstand R innerhalb des Massezweigs, sondern direkt mit dem Minuspol M des Ackupacks 10 verbunden ist.

Fig. 2 zeigt einen Algorithmus zur Erkennung der elektrischen Fehler F₁ - F₄ innerhalb der Eingangsschaltung 120 der Überwachungseinheit 110 des Akkupacks 100 von Fig. 1 mit Hilfe der Überwachungseinheit 110. In einem Schritt 202 erfolgt der Start eines Ladevorgangs des Akkupacks 100. In einem Schritt 204 wird bei jedem Durchlaufen eine andere Akkuzelle und ein anderer Kanal des Eingangsfilters ausgewählt. Im Anschluss daran erfolgt in einem Schritt 206 das Messen der Spannung U_{1,..,n}(t₁) zu einem ersten Zeitpunkt t₁. Des Weiteren wird in einem Schritt 208 einer der Schalter S_{1,...,5} ausgewählt und zumindest kurzzeitig geschlossen. In einem sich anschließenden Schritt 210 wird der betreffende Schalter S_{1,...,5} wieder geöffnet und die Zeitmesseinheit, bzw. ein Timer innerhalb der Überwachungseinheit 110, gestartet. Danach erfolgt in einem Schritt 212 eine kontinuierliche Messung der aktuellen Spannung U_{1,...,n} (t₂). In einem nachfolgenden Abfrageschritt 214 erfolgt ein kurzer Test, ob die aktuelle Spannung U_{1,...,n}, (t₂) bei Null Volt liegt. Ist dies nicht der Fall, so wird über einen Pfad 280 in einem Schritt 230 ein unverzüglicher Stopp des Ladebetriebs veranlasst. Anderenfalls wird in einem Schritt 216 die betreffende Spannung U_{1,...,n} (t₂) solange weiter gemessen, bis diese wieder einen Bruchteil von vorzugsweise 0,1 bis 0,9 der ursprünglichen Spannung U_{1,...,5} (t₁) erreicht hat. In einem nachfolgenden Abfrageschritt 218 erfolgt noch eine kurze Prüfung, ob die Spannung U_{1,...,n}, (t₂) stetig ansteigt. Ist dies nicht der Fall erfolgt über einen Pfad 282 im Schritt 230 wiederum der sofortige Stopp des Ladebetriebs. Steigt die Spannung U_{1,...,n} (t₂) jedoch stetig an, so wird die Zeitmesseinheit gestoppt und die betreffende Anstiegszeit T_{An 1,...,n} kann aus der Differenz zwischen dem zweiten Zeitpunkt t₂ beim Stoppen der Zeitmessung und dem ersten Zeitpunkt t₁ berechnet werden. Für die Anzahl n gleich Eins (n=1) ist es hierbei ggf. erforderlich, die Zeit t_{An 1} noch um einen numerischen Korrekturfaktor zu berichtigen.

In einem Abfrageschritt 222 erfolgt noch ein Test, ob die Anzahl von n Eingängen durchlaufen ist, das heißt ob alle Eingänge mit Akkuzellen überprüft sind. Ist dies nicht der Fall, so erfolgt über einen (Rücksprung-) Pfad 284 ein Rücksprung auf den Schritt 204. Anderenfalls erfolgt mittels eines Pfads 286 die Weiterleitung auf einen Schritt 224, in dem hier lediglich exemplarisch eine absolute Bewertung aller gemessenen Anstiegszeiten T_{An 1,...,n} dahingehend erfolgt, ob diese in einem vorgegebenen Toleranzbereich liegen. In einem weiteren Abfrageschritt 226 erfolgt eine Überprüfung, ob sämtliche Toleranzbereiche eingehalten sind. Ist dies der Fall, so erfolgt in einem Schritt 228 die Fortführung des Ladebetriebs, anderenfalls erfolgt über einen weiteren (Sprung-) Pfad 288 der sofortige Stopp des Ladebetriebs in dem Schritt 230. Prinzipbedingt muss ein Toleranzbereich bei einer absoluten Bewertung der Anstiegszeiten T_{An 1,...,n} recht groß bemessen sein, um alle Abweichungen aufgrund des Alterungsprozesses der Akkuzellen und der aktiven und passiven elektronischen Bauteile angemessen zu berücksichtigen.

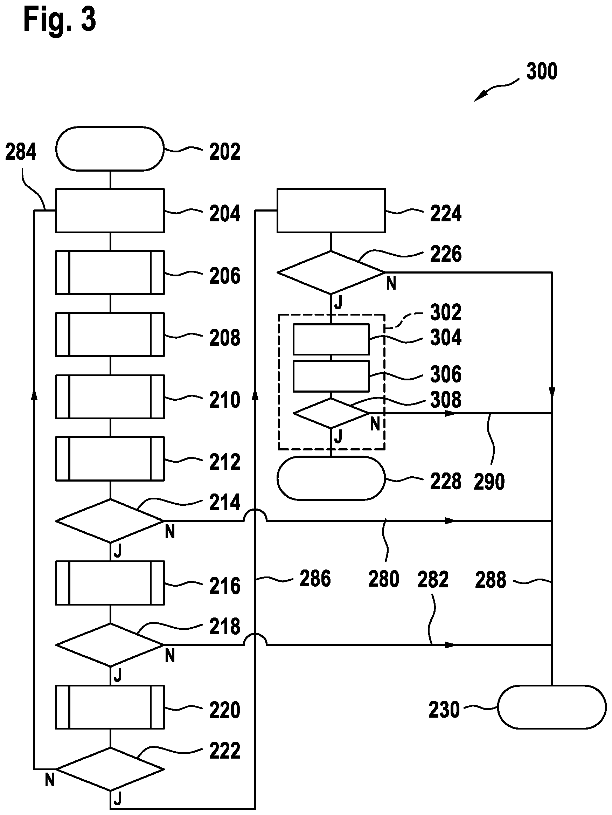

Fig. 3 zeigt einen weiteren alternativen Algorithmus zur Erkennung der elektrischen Fehler. Bevorzugt sind die Schritte 202 bis 230 des Algorithmus 200 von Fig. 2 identisch mit den Schritten 202 bis 230 sowie den Pfaden 280 bis 288 des hier veranschaulichten Algorithmus 300, so dass zwecks Knappheit und Kürze der Beschreibung an dieser Stelle auf die im Rahmen der Erläuterung der Fig. 2 gemachten Ausführungen verwiesen werden kann.

Als einziger Unterschied zum Algorithmus 200 von Fig. 2 realisiert der Algorithmus 300 von Fig. 3 zusätzlich eine relative Auswertung bzw. Bewertung der Anstiegszeiten T_{An 1,...,n}, die in einem zusätzlich angefügten, gestrichelt umrandeten Programmteil 302, umfassend der Schritte 304, 306, sowie einem Abfrageschritt 308, umgesetzt ist.

In einem dem Abfrageschritt 226 nachfolgenden Schritt 304 erfolgt zunächst eine Berechnung einer maximalen Spreizung der Anstiegszeiten T_{An 1,...,n} mit Hilfe einer Differenzbildung zwischen einer vorab ermittelten, minimalen und einer maximalen Anstiegszeit T_{An 1,..,n}. In einem Schritt 306 erfolgt dann die eigentliche relative Bewertung an Hand eines Vergleichs der maximalen Spreizung der Anstiegszeiten T_{An 1,...,n} mit einem vorgegebenen und bevorzugt in der Überwachungseinheit 110 hinterlegten Toleranzbereich bzw. einem vordefinierten Toleranzintervall. In einem Abfrageschritt 308 erfolgt ein Test, ob die maximale Spreizung im Toleranzbereich liegt. Ist dies der Fall, erfolgt im Schritt 228 die Fortführung des Ladebetriebs. Anderenfalls erfolgt über einen weiteren (Sprung-) Pfad 290 im Schritt 230 wiederum der unverzügliche Abbruch des Ladebetriebs.

Eine alleinige relative Bewertung der Anstiegszeiten T_{An 1,...,n} mit Hilfe vorgegebener Toleranzbereiche ist grundsätzlich möglich. Systematische Fehler, wie zum Beispiel eine Fehlbestückung sämtlicher Kondensatoren mit demselben, aber falschen Kapazitätswert, lassen sich jedoch mittels der relativen Bewertung nicht ermitteln. Der Vorteil der relativen Toleranzbewertung offenbart sich erst in der hier illustrierten Kombination mit der absoluten Toleranzbewertung gemäß Fig. 2. Weiterhin kann der Toleranzbereich im Fall der relativen Bewertung enger bemessen sein als bei der absoluten Bewertung. Denn es ist davon auszugehen, dass gleiche Komponenten innerhalb der Eingangsschaltung 120 auch stets derselben Alterung unterliegen.

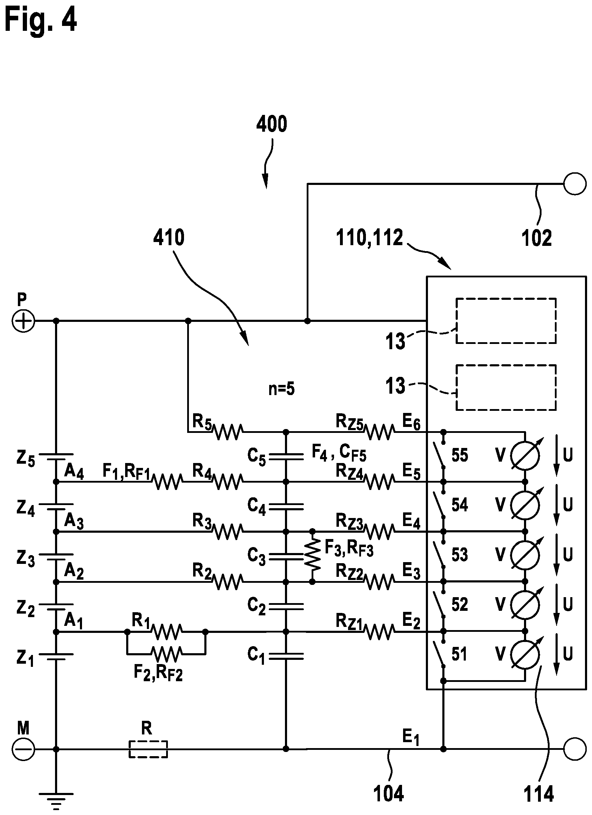

Fig. 4 zeigt einen weiteren Akkupack 400, der als Unterschied zum Akkupack 100 von Fig. 1 über eine mit Zusatzwiderständen R_{Z1,...,5} modifizierte Eingangsschaltung 410 verfügt, so dass zwecks Knappheit der Beschreibung hinsichtlich der Erläuterung der weiteren aktiven und passiven elektronischen Bauteile des Akkupacks 400 an dieser Stelle auf die Beschreibung von Fig. 1 verwiesen wird. Vorzugsweise weist die passive Eingangsschaltung 410 mehrere Zusatzwiderstände R_{Z1,..,n} auf, die jeweils in Reihe mit einem der Widerstände R_{1,..,n} geschaltet sind, wobei die Anzahl der Zusatzwiderstände R_{Z1,...,n} bevorzugt gleich der vorgegebenen Anzahl n der Akkuzellen Z_{1,...,n} ist.

In der modifizierten Eingangsschaltung 410 von Fig. 4 sind bei der erneut exemplarisch vorgegebenen Anzahl von n gleich fünf (n=5) Akkuzellen Z_{1,...,5} des Akkupacks 400 entsprechend illustrativ fünf von den Zusatzwiderständen R_{Z1,...,5} vorgesehen, die jeweils in Reihe zu den Widerständen R_{1,...,5} geschaltet sind und die hierbei jeweils direkt vor einem der Eingänge E_{2,...,6} der Überwachungseinheit 110 liegen. Die illustrativ fünf Zusatzwiderstände R_{Z1,...,5} sind jeweils kleiner oder höchstens gleich als die anderen Widerstände R_{1,...,5} bemessen. Bevorzugterweise beträgt ein Widerstandswert der Zusatzwiderstände R_{Z1,...,5} zwischen 20 % und 80 % eines Widerstandswertes der Widerstände R_{1,..,5}. Besonders bevorzugt weist der eine Widerstandswert der Zusatzwiderstände R_{Z1,...,5} einen Widerstandswert, der zwischen 20 % und 50 % eines Widerstandswertes der Widerstände R_{1,..,5} liegt, auf. Die Anzahl der Zusatzwiderstände R_{Z1,...,5} korrespondiert bevorzugt mit der Anzahl n der Akkuzellen Z_{1,...,5} und der Anzahl n der Widerstände R_{1,...,5}, entspricht hier also der Zahl Fünf. Es wird jedoch darauf hingewiesen, dass die Anzahl der Zusatzwiderstände R_{Z1,...,5} auch ungleich der Anzahl der Akkuzellen Z_{1,...,5} und/oder der Widerstände R_{1,..,}5 sein kann. Die Zusatzwiderstände R_{Z1,...,5} bewirken eine Stromdämpfung innerhalb der Eingangsschaltung 410 der Überwachungseinheit 110.

Anstatt der fünf elektronischen Schalter S_{1,...5} in der Überwachungseinheit 110 können auch andere aktive oder passive elektronische Komponenten vorgesehen sein, die es erlauben, anstatt einen definierten Kurzschluss hervorzurufen, einen spezifizierten elektrischen Strom zu ziehen oder einen definierten elektrischen Widerstand zuzuschalten. Diese Komponenten können ein Teil der SCM-Schaltung 112 sein, alternativ aber auch in die passive Eingangsschaltung 410 - wie es in Fig. 4 exemplarisch illustriert ist - integriert sein.

Im Fall der hier gegebenen Bewertung einer Abfallkurve der (Eingangs-) Spannungen U_{1,...,5} zur Fehlererkennung innerhalb der Eingangsschaltung 410 des Akkupacks 400 wird ein vom Algorithmus bestimmter elektronischer Schalter S_{1,...,5} über ein definiertes Zeitintervall hinweg geschlossen. Zu Beginn des Zeitintervalls bzw. unmittelbar nach dem Wirksamwerden des Schließvorgangs des betreffenden Schalters S_{1,...,n} in einem ersten Zeitpunkt t₁, wird eine zugeordnete aktuelle (Eingangs-) Spannung U_{1,...,5}(t₁) gemessen. Nach dem Ablauf des Zeitintervalls, bzw. zu einem zweiten Zeitpunkt t₂, wird der betreffende Schalter S_{1,...,5} wieder geöffnet und unmittelbar danach die zugehörige (Eingangs-) Spannung U_{1,...,5}(t₂) gemessen. Im Anschluss daran wird das Verhältnis von U_{1,...,5}(t₂) / U_{1,...,5}(t₁) vorzugsweise mittels des Mikrokontrollers 130 der Überwachungseinheit 110 berechnet. "Unmittelbar" deshalb, da anderenfalls der zugehörige Kondensator C_{1,...,5} von der ihm zugeordneten Zelle Z_{1,...5} wieder nachgeladen würde, was zu einer Verfälschung der Messung der Abfallkurve führen würde. Die Erfassung der beiden Zeitpunkte t₁, t_{,2} kann zum Beispiel mittels der von dem Mikrokontroller 130 gesteuerten Zeitmesseinheit 132 der Überwachungseinheit 110 erfolgen. Dabei ist die Differenz zwischen dem zweiten Zeitpunkt t₂ und dem ersten Zeitpunkt t₁ gleich dem festgelegten Zeitintervall.

Das Verhältnis der beiden Spannungen U_{1,...,5}(t₂) / U_{1,...,5}(t₁) kann dann wiederum entsprechend zu den im Rahmen der Beschreibung der Fig. 1 bis 3 gemachten Ausführungen anhand eines geeignet vorgegebenen Toleranzbereichs absolut und/oder relativ bewertet und damit zur Erfassung der vier elektrischen Fehler F_{1,...,4} innerhalb der Eingangsschaltung 410 des Akkupacks 400 herangezogen werden. Ein besonderer Vorteil des Akkupacks 400 sowie der Bewertung der Abfallkurve liegt darin, dass auch zwei sich gegenseitig kompensierende Fehler, beispielsweise wenn die Werte einer Paarung 1/R_{1,...,5} und C_{1,...5} sich in dem gleichem Maße verändern, so dass das Produkt aus R und C konstant bleibt, erfasst werden können.

## Patentansprüche

1. Akkupack mit einer vorgegebenen Anzahl (n) von miteinander verschalteten einzelnen Akkuzellen (Z_{1,...,n}) und einer Überwachungseinheit (110), insbesondere nach Art einer Single-Cell-Monitoring-Schaltung (112), für die Überwachung der einzelnen Akkuzellen (Z_{1,...,n}), wobei die Überwachungseinheit (110) mindestens einen Spannungsmesser (V_{1,...,n}) zur Erfassung von Spannungen (U_{1,...,n}) der einzelnen Akkuzellen (Z_{1,...,n}) mit jeweils zugeordneten elektronischen Schaltern (S_{1,...,n}) sowie mit einer passiven Eingangsschaltung (120), welche mehrere Widerstände (R_{1,...,n}) und Kondensatoren (C_{1,...,n}) aufweist und dazu ausgebildet ist, unterschiedliche elektrische Fehler (F_{1,...,4}) innerhalb der passiven Eingangsschaltung (120) mittels einer der Überwachungseinheit (110) zugeordneten Zeitmesseinheit (132) anhand einer Messung von Anstiegszeiten (T_{An 1,...,n}) der Spannungen (U_{1,..,n}) der einzelnen Ackuzellen (Z_{1,...,n}) zu erkennen, **dadurch gekennzeichnet, dass** die elektrischen Fehler (F_{1,...,4}) innerhalb der passiven Eingangsschaltung (120) jeweils durch eine absolute und/oder relative Auswertung der Anstiegszeiten (T_{An 1,...,5}) der Spannungen (U_{1 ,..,n}) der einzelnen Akkuzellen (Z_{1,...,n}) durch zumindest kurzzeitiges Überbrücken jeweils eines der Spannungsmesser (V_{1,..,n}) der Überwachungseinheit (110) mittels eines zugeordneten Schalters (S_{1,..,n}) erkannt werden.

2. Akkupack nach Anspruch 1, **dadurch gekennzeichnet, dass** die passive Eingangsschaltung (410) mehrere Zusatzwiderstände (R_{Z1,...,n}) aufweist, die jeweils in Reihe mit einem der Widerstände (R_{1,...,n}) geschaltet sind, wobei die Anzahl der Zusatzwiderstände (R_{z1,...,n}) gleich der vorgegebenen Anzahl (n) der Akkuzellen (Z_{1,...,n}) ist.

3. Akkupack nach Anspruch 2, **dadurch gekennzeichnet, dass** die Zusatzwiderstände (R_{z1,...,n}) kleiner oder gleich als die Widerstände (R_{1,...,n}) bemessen sind.

4. Akkupack nach einem der vorherigen Ansprüche, **dadurch gekennzeichnet, dass** die Überwachungseinheit (110) als eine integrierte Schaltung (114) ausgeführt ist.

5. Verfahren zur Erfassung von elektrischen Fehlern (F1,...,4) innerhalb einer passiven Eingangsschaltung (120) einer Überwachungseinheit (110), insbesondere nach Art einer Single-Cell-Monitoring-Schaltung (112), für die Überwachung einer vorgegebenen Anzahl (n) von einzelnen Akkuzellen (Z_{1,...,n}) eines Akkupacks (100), insbesondere eines Akkupacks (100) nach einem der vorhergehenden Ansprüche, wobei die Eingangsschaltung (120) mehrere Widerstände (R_{1,...,n}) und Kondensatoren (C_{1,...,n}) aufweist, **gekennzeichnet durch** die folgende Schritte:
a. Start eines Ladebetriebs des Akkupacks (100),
b. Messen einer Spannung (U_{1,...,n}(t₁)) einer Akkuzelle (Z_{1,...,n}) zu einem ersten Zeitpunkt (t₁),
c. zumindest kurzzeitiges Überbrücken eines Spannungsmessers (V_{1,..,n}) der Überwachungseinheit (110) mittels eines zugeordneten Schalters (S_{1,...,n}),
d. Messen einer Anstiegszeit (T_{AH 1,...,n}) der Spannung (U_{1,...,n}) bis eine zu einem zweiten Zeitpunkt (t₂) gemessene Spannung (U_{1,..,n}(t₂)) das 0,1-bis 0,9-Fache der in Schritt b) gemessenen Spannung (U_{1,...,n} (t₁)) erreicht hat,
e. Wiederholen der Schritte b) bis d) für jede der vorgegebenen Anzahl (n) von Akkuzellen (Z_{1,...,n}) des Akkupacks (100),
f. absolutes und/oder relatives Auswerten der Anstiegszeiten (T_{AN 1,...,n}) der Spannung (U_{1,..,n}) der einzelnen Akkuzellen (Z_{1,...,n}) anhand eines vorgegebenen Toleranzbereichs, und
g. Stopp des Ladebetriebs des Akkupacks (100), wenn mindestens eine Anstiegszeit (T_{AN 1,...,n}) außerhalb des Toleranzbereichs liegt und somit ein Fehler (F_{1,...,4}) innerhalb der passiven Eingangsschaltung (120) der Überwachungseinheit (110) erkannt wurde, andernfalls Fortsetzen des Ladebetriebs und zyklisches Wiederholen der Schritte b) bis g).

6. Verfahren nach Anspruch 5, **dadurch gekennzeichnet, dass** bei der vorgegebenen Anzahl (n) gleich Eins die Anstiegszeit (T_{AN 1}) um einen zeitlichen Korrekturfaktor berichtigt wird, wenn der erste Spannungsmesser (V₁) nicht über einen elektrischen Widerstand (R) mit einem Minuspol (M) des Akkupacks (100, 400) verbunden ist.

## Claims

1. Rechargeable battery pack comprising a predefined number (n) of individual rechargeable battery cells (Z_{1,...,n}) that are connected to one another and a monitoring unit (110), in particular in the form of a single cell monitoring circuit (112), for monitoring the individual rechargeable battery cells (Z_{1,...,n}), wherein the monitoring unit (110) has at least one voltmeter (V_{1,...},ₙ) for detecting voltages (U_{1,...,n}) of the individual rechargeable battery cells (Z_{1,...,n}) with respectively assigned electronic switches (S_{1,...,n}) and with a passive input circuit (120) that has a plurality of resistors (R_{1,...,n}) and capacitors (C_{1,...,n}) and is designed to identify different electrical faults (F_{1,..,4}) within the passive input circuit (120) by means of a time measuring unit (132), which is assigned to the monitoring unit (110), on the basis of a measurement of rise times (T_{An 1,...,n)} of the voltages (U_{1,...,n}) of the individual rechargeable battery cells (Z_{1,...n}), **characterized in that** the electrical faults (F_{1,...,4}) within the passive input circuit (120) are each identified by an absolute and/or relative evaluation of the rise times (T_{An 1,...,5}) of the voltages (U_{1,...,n}) of the individual rechargeable battery cells (Z_{1,...,n}) by at least temporarily bypassing in each case one of the voltmeters (V_{1,...},ₙ) of the monitoring unit (110) by means of an assigned switch (S_{1,...,n}) .

2. Rechargeable battery pack according to Claim 1, **characterized in that** the passive input circuit (410) has a plurality of additional resistors (R_{Z1,... ,n}) that are each connected in series with one of the resistors (R_{1,...,n}), wherein the number of additional resistors (R_{Z1,...,n}) is equal to the predefined number (n) of rechargeable battery cells (Z_{1,...,n}).

3. Rechargeable battery pack according to Claim 2, **characterized in that** the additional resistors (R_{Z1,...,n}) are dimensioned to be smaller than or the same as the resistors (R_{1,...,n}).

4. Rechargeable battery pack according to one of the preceding claims, **characterized in that** the monitoring unit (110) is in the form of an integrated circuit (114).

5. Method for detecting electrical faults (F1,...,4) within a passive input circuit (120) of a monitoring unit (110), in particular in the form of a single cell monitoring circuit (112), for monitoring a predefined number (n) of individual rechargeable battery cells (Z_{1,...,n}) of a rechargeable battery pack (100), in particular a rechargeable battery pack (100) according to one of the preceding claims, wherein the input circuit (120) has a plurality of resistors (R_{1,...,n}) and capacitors (C_{1,...,n}), **characterized by** the following steps:
a. starting a charging operation of the rechargeable battery pack (100),
b. measuring a voltage (U_{1,...,n}(t₁)) of a rechargeable battery cell (Z_{1,...,n}) at a first time (t₁),
c. at least temporarily bypassing a voltmeter (V_{1,...,n}) of the monitoring unit (110) by means of an assigned switch (S_{1,...,n}),
d. measuring a rise time (T_{An 1,...,n}) of the voltage (U_{1,...,n}) to a voltage (U_{1,...,n}(t₂)) measured at a second time (t₂) that has reached 0.1 to 0.9 times the voltage (U_{1,...,n}(t₁)) measured in step b),
e. repeating steps b) to d) for each of the predefined number (n) of rechargeable battery cells (Z_{1,...,n}) of the rechargeable battery pack (100),
f. absolutely and/or relatively evaluating the rise times (T_{An 1,...,n}) of the voltage (U_{1,...,n}) of the individual rechargeable battery cells (Z_{1,...,n}) on the basis of a predefined tolerance range, and
g. ending the charging operation of the rechargeable battery pack (100) if at least one rise time (T_{AN 1,...,n}) is outside of the tolerance range and therefore a fault (F_{1,...,4}) has been identified within the passive input circuit (120) of the monitoring unit (110), otherwise continuing the charging operation and cyclically repeating steps b) to g).

6. Method according to Claim 5, **characterized in that**, if the predefined number (n) is equal to one, the rise time (T_{AN 1}) is corrected by a temporal correction factor if the first voltmeter (V₁) is not connected to a negative pole (M) of the rechargeable battery pack (100, 400) via an electrical resistor (R).

## Revendications

1. Bloc-batterie comprenant un nombre (n) prédéfini d'éléments de batterie (Z_{1,...,n}) individuels connectés les uns aux autres et une unité de surveillance (110), notamment à la manière d'un circuit de surveillance d'élément unique (112), pour la surveillance des éléments de batterie (Z_{1,...,n}) individuels, l'unité de surveillance (110) comprenant au moins un voltmètre (V_{1,...,n}) destiné à détecter les tensions (U_{1,...,n}) des éléments de batterie (Z_{1,...,n}) individuels avec des commutateurs électroniques (S_{1,...,n}) respectivement associés ainsi qu'avec un circuit d'entrée passif (120), qui possède plusieurs résistances (R_{1,...,n}) et condensateurs (C_{1,...,n}) et qui est configuré pour reconnaître différents défauts (F_{1,...,4}) électriques à l'intérieur du circuit d'entrée passif (120) au moyen d'une unité de mesure de temps (132) associée à l'unité de surveillance (110) à l'aide d'une mesure des temps de montée (T_{An 1,...,n}) des tensions (U_{1,...,n}) des éléments de batterie (Z_{1,...,n}) individuels, **caractérisé en ce que** les défauts (F_{1,...,4}) électriques à l'intérieur du circuit d'entrée passif (120) sont respectivement reconnus par une évaluation absolue et/ou relative des temps de montée (T_{An 1,...,5}) des tensions (U_{1,...,n}) des éléments de batterie (Z_{1,...,n}) individuels par un pontage au moins de courte durée respectivement de l'un des voltmètres (V_{1,...,n}) de l'unité de surveillance (110) au moyen d'un commutateur (S_{1,...,n}) associé.

2. Bloc-batterie selon la revendication 1, **caractérisé en ce que** le circuit d'entrée passif (410) présente plusieurs résistances supplémentaires (R_{Z1, ..., n}), qui sont respectivement montées en série avec l'une des résistances (R_{1, ..., n}), le nombre de résistances supplémentaires (R_{Z1, ..., n}) étant égal au nombre prédéterminé (n) d'éléments de batterie (Z_{1, ..., n}).

3. Bloc-batterie selon la revendication 2, **caractérisé en ce que** les résistances supplémentaires (R_{Z1,...,n}) sont dimensionnées plus petites ou égales aux résistances (R_{1,...,n}).

4. Bloc-batterie selon l'une des revendications précédentes, **caractérisé en ce que** l'unité de surveillance (110) est réalisée sous la forme d'un circuit intégré (114).

5. Procédé de détection de défauts (F1, ...,4) électriques à l'intérieur d'un circuit d'entrée passif (120) d'une unité de surveillance (110), notamment à la manière d'un circuit de surveillance d'élément unique (112), pour la surveillance d'un nombre (n) prédéfini d'éléments de batterie (Z_{1,. ...,n}) individuels d'un bloc-batterie (100), notamment d'un bloc-batterie (100) selon l'une des revendications précédentes, le circuit d'entrée (120) possédant plusieurs résistances (R_{1,...,n}) et condensateurs (C_{1,...,n}), **caractérisé par** les étapes suivantes :
a. démarrage d'un régime de charge du bloc-batterie (100),
b. mesure d'une tension (U_{1,...,n}(t₁)) d'un élément de batterie (Z_{1,...,n}) à un premier instant (t₁),
c. pontage au moins de courte durée d'un voltmètre (V_{1,...,n}) de l'unité de surveillance (110) au moyen d'un commutateur (S_{1,...,n}) associé,
d. mesure d'un temps de montée (T_{An 1,...,n}) de la tension (U_{1,...,n}) jusqu'à une tension (U_{1,...,n}(t₂)) mesurée à un deuxième instant (t₂) qui a atteint 0,1 à 0,9 fois la tension (U_{1,...,n}(t₁)) mesurée à l'étape b),
e. répétition des étapes b) à d) pour chacun des nombres (n) prédéfinis d'éléments de batterie (Z_{1,...,n}) du bloc-batterie (100),
f. évaluation absolue et/ou relative des temps de montée (T_{An 1,...,n}) de la tension (U_{1,...,n}) des éléments de batterie (Z_{1,...,n}) individuels à l'aide d'une plage de tolérance prédéfinie, et
g. arrêt du régime de charge du bloc-batterie (100) lorsqu'au moins un temps de montée (T_{AN 1,...,n}) se trouve en dehors de la plage de tolérance et qu'ainsi un défaut (F_{1,...,4}) a été reconnu à l'intérieur du circuit d'entrée passif (120) de l'unité de surveillance (110), sinon poursuite du régime de charge et répétition cyclique des étapes b) à g).

6. Procédé selon la revendication 5, **caractérisé en ce que**, pour le nombre (n) prédéterminé égal à un, le temps de montée (T_{AN 1}) est corrigé par un facteur de correction temporel lorsque le premier voltmètre (V₁) n'est pas relié à un pôle négatif (M) du bloc-batterie (100, 400) par le biais d'une résistance électrique (R).
